(19) Europäisches Patentamt
European Patent Office
Office européen des brevets

(11) EP 0 805 561 A2

(12) EUROPEAN PATENT APPLICATION

(43) Date of publication:
05.11.1997 Bulletin 1997/45

(51) Int Cl.$^6$: H04B 1/30

(21) Application number: 97660051.0

(22) Date of filing: 29.04.1997

(84) Designated Contracting States:
DE FR GB SE

(30) Priority: 03.05.1996 FI 961887

(71) Applicant: NOKIA MOBILE PHONES LTD.
02150 Espoo (FI)

(72) Inventors:
• Scheck, Hans-Otto
43 02360 Espoo (FI)

• Hyyryläinen, Jari
02880 Veikkola (FI)
• Pulkkinen, Otto
00210 Helsinki (FI)

(74) Representative: Tanhua, Pekka Vilhelm
Berggren Oy Ab,
P.O. Box 16
00101 Helsinki (FI)

(54) A method for implementing a direct conversion receiver with a six-port junction

(57) The invention relates to a method for receiving and demodulating information transmitted as modulated by a direct conversion receiver, which comprises a six-port junction (4). In this method the demodulation is carried out analogically.

Fig. 1

**Description**

The invention relates to a method claimed in the preamble of Claim 1 for implementing a coherent and an incoherent direct conversion receiver with a six-port junction, and to a coherent and an incoherent direct conversion receiver in accordance with the method.

In a direct conversion receiver, the radio frequency signals are converted directly into baseband signals, such as I and Q signals (Inphase, Quadrature). This reduces the number of high frequency components needed in the receiver, whereby the degree of integration can be increased. The direct conversion receivers are thus particularly well suited for use in mobile stations.

Conventionally, a direct conversion receiver is implemented by using two mixers, phase shiftes and power dividers, whereby the received RF signal and the local oscillator frequency are led to the first mixer, and the received RF signal and the local oscillator frequency, one of which has a phase shift of 90°, are led to the second mixer. In this implementation the problem is to achieve mixers, phase shiftes and power dividers that are as ideal as possible. The imbalance between the I and Q signals and the D.C. offset that occurs particularly in the mixers causes a deterioration of the receiver sensitivity, if there are other strong signals in the vicinity of the received RF signal.

One object of the present invention is to eliminate the above mentioned drawbacks and to achieve a method for implementing a direct conversion receiver and a coherent and an incoherent direct conversion receiver implemented with this method. The method according to the invention is based on the use of a known six-port junction, by which the received RF signal is combined with the local oscillator frequency with different phase shifts. The demodulation of the transmitted information is carried out so that a power signal corresponding to each output signal is produced from the four output signals of the six-port junction. Four power meters are used to measure the power signals produced. In addition, analog adders are used to produce baseband signals from the output signals of the power meters. Baseband I and Q signals are received from the incoherent receiver, and baseband amplitude and phase signals are received from the coherent receiver. The method according to the invention is characterized in what is said in the characterizing part of Claim 1. An incoherent direct conversion receiver according to the invention is characterized in what is said in the characterizing part of Claim 6. A coherent direct conversion receiver according to the invention is characterized in what is said in the characterizing part of Claim 7.

Remarkable advantages are achieved by the invention. The method according to the invention does not apply mixers but power meters, which can be implemented in a less complicated manner and they can be planned to great accuracy, whereby the problems caused by the nonlinearity of the mixers can be avoided. Possible deviations from ideality of the receiver can easily be eliminated by calibration. A diode, for example, can be used as a power meter. A coherent receiver can be implemented by using feedback, whereby the phase difference between the received signal and the local oscillator frequency is kept essentially constant. Thus the signals of the outputs of the coherent six-port junction are directly proportional to the phase and amplitude of the received signal. A coherent receiver is preferable in the reception of an amplitude or frequency modulated signal. This provides a better signal-to-noise ratio than in the case of an incoherent receiver. In addition, the demodulated analog signal is received directly. Feedback is not needed in an incoherent receiver implemented with a six-port junction, and the baseband I and Q signals are obtained from the receiver. In addition, relatively low-cost components can be used in the manufacture of a receiver in accordance with the invention.

In the following, the invention will be described in more detail with reference to the appended drawings, in which

Figure 1 shows an incoherent direct conversion receiver according to the invention as a simplified block diagram,

Figure 2 shows a coherent direct conversion receiver according to the invention as a simplified block diagram,

Figure 3a shows the output spectrum of the mixer of a conventional direct conversion receiver in the frequency domain, and

Figure 3b shows the output spectrum of one port of the six-port junction in the frequency domain.

An incoherent direct conversion receiver with a six-port junction can be implemented as follows.

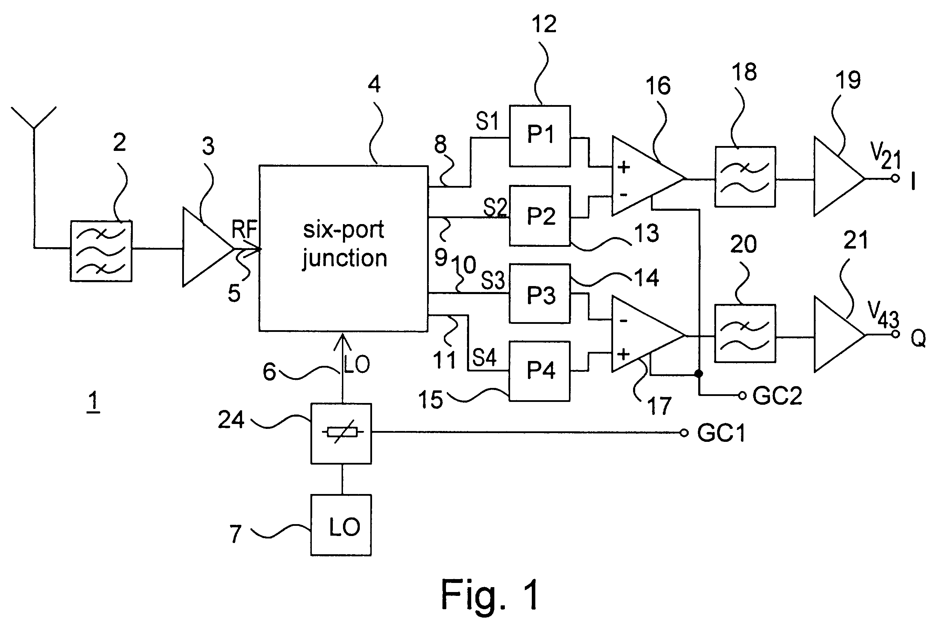

A high-frequency signal is brought to the receiver shown in Figure 1 via an antenna ANT. From the antenna ANT the high frequency signal is led to a passband filter 2, where signals outside the reception frequency band are filtered out from the received signal. The passband filtered signal is amplified in a high frequency amplifier 3. The amplified high-frequency signal is further directed to the first input port 5 of the six-port junction 4.

A frequency produced by the local oscillator 7, which is of the reception channel frequency, is led to the second input port 6 of the six-port junction 4. In the six-port junction, the received RF signal led to the first input port 5 is summed to the local oscillator frequency LO led to the second input port in different phases, whereby four different output signals S1, S2, S3, S4 are produced at the output ports 8, 9, 10, 11 of the six-port junction. The local oscillator frequency LO is set at the reception channel frequency. The first output signal S1 is the sum of the received signal RF and the local oscillator frequency LO. The second output signal S2 is the difference of the received signal RF and the local oscillator frequency LO. The third output signal S3 is the sum of the received signal RF and the local oscillator frequency LO, which have a 90° phase difference. The fourth output signal S4 is the difference of the received signal RF and the local oscillator frequency LO, which have a 90° phase difference. Higher frequency components are also produced in the summing, and these can be removed by low-pass filtering.

From the first output port 8 the first output signal S1 is led to the first power measurement device 12, which is preferably a diode. Similarly, from the second output port 9 the second output signal S2 is led to the second power measurement device 13, from the third output port 10 the third output signal S3 is led to the third power measurement device 14, and from the fourth output port 11 the fourth output signal S4 is led to the fourth power measurement device 15.

The first power measurement device 12 produces the first power signal P1, which is the square of the first output signal S1 ($S1^2$). The other power signals P2, P3, P4 are produced by squaring the corresponding output signal S2, S3, S4. A difference of the first power signal P1 and the second power signal P2 is produced in the first adder 16, the difference is low-pass filtered in the first low-pass filter 18 and amplified in the first low-frequency amplifier 19. Thus a baseband I signal is received from the output of the first low-frequency amplifier 19. A difference of the fourth power signal P4 and the third power signal P3 is produced in the second adder 17, and the difference is low-pass filtered in the second low-pass filter 20 and amplified in the second low-frequency amplifier 21. A baseband Q signal is received from the output of the second low-frequency amplifier 21.

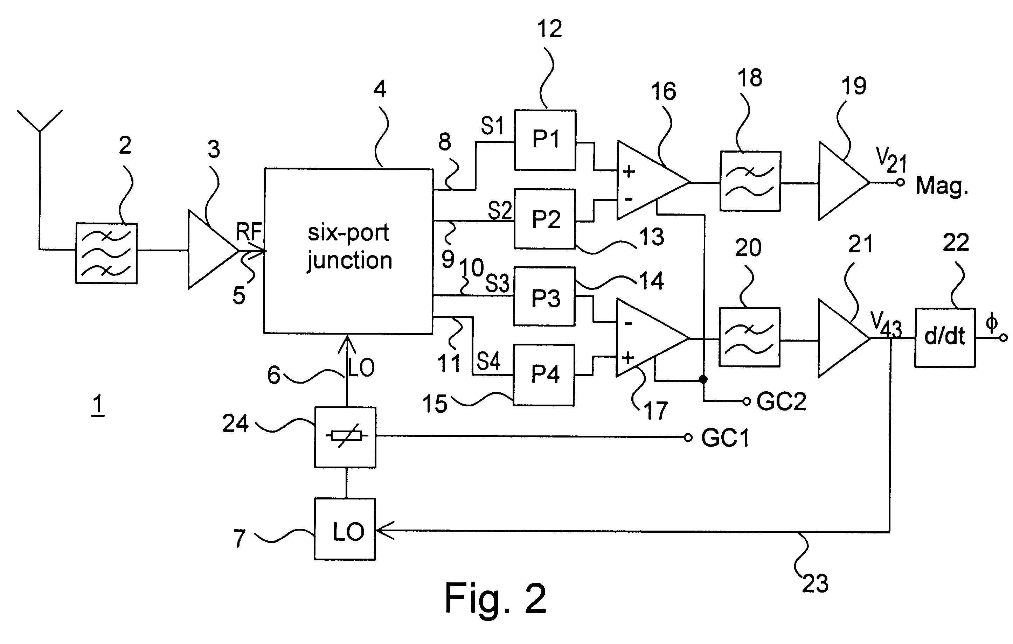

A coherent receiver with a six-port junction can be implemented by adding a feedback according to Figure 2 from the Q branch to the local oscillator 7. Then the amplitude of the received signal is obtained from the I branch and the phase from the output of the derivator 22. The signal produced by the second low-frequency amplifier 21 is used to control the phase of the local oscillator frequency LO, whereby the phase difference between the received radio frequency signal RF and the local oscillator frequency LO can be held essentially constant.

The six-port junction used in a coherent and an incoherent receiver application can be preferably implemented by a phase detector or by a correlator junction, as has been set forth, for example, in the article "An automatic microwave phase measurement system", Microwave Journal, Vol. 7, Feb. 1964. A six-port junction like this can consist of three phase shifters and one power divider circuit.

The adders 16, 17, low-pass filters 18, 20 and low-frequency amplifiers 19, 21 can also be implemented at least partly by using a digital signal processing (DSP) unit, in which case A/D converters are also needed for converting the analog signal into digital. However, a drawback of this application is the fact that particularly the A/D converters must be wideband, whereby the receiver becomes more expensive than when implemented using analog technique. The power consumption of the receiver also increases.

In the following, the method according to the invention will be described mathematically. The transmitted information is contained in the I and Q components. For the determination thereof, the received radio-frequency signal RF (denoted with b in the following equations) can be divided by the local oscillator frequency LO (denoted with a in the following equations). Thus we get

$$\frac{b}{a} = \frac{b_x + b_y \cdot i}{a_x + a_y \cdot i} = \frac{(a_x - a_y \cdot i) \cdot (b_x + b_y \cdot i)}{a_x^2 + a_y^2} = \frac{1}{a^2}\,(a_x b_x + a_y b_y + i \cdot (a_x b_y - a_y b_x)) \qquad [1]$$

where $a_x, b_x$ and $a_y, b_y$ are the I and Q components of the received radio frequency signal '$b$' and the local oscillator frequency '$a$'.

From the equation [1] it can be seen that the I and Q components of the demodulated signal are

$$I = \frac{1}{|a|^2}\,(a_x b_x + a_y b_y) \qquad [2]$$

$$Q = \frac{1}{|a|^2}\,(a_x b_y - a_y b_x) \qquad [3]$$

These can be also presented in the form

$$\frac{b}{a} = \frac{|b|}{|a|} \exp(i\phi) = \frac{|b||a|}{|a|^2} (\cos\phi + i\cdot\sin\phi) \qquad [4]$$

A common, known solution for determining $|a|$, $|b|$ and $|\phi|$ is to select four functions out of six possible, different functions. This has been set forth, for example, in the publication IEEE Transactions on Microwave Theory and Techniques, Vol. 23, No. 12, December 1, 1975: "Using an Arbitrary Six-Port Junction to Measure Complex Voltage Ratios". The selected functions must be linearly independent. The functions are divided into three groups, which are shown in Table 1. Four independent functions can be selected from Table 1 so that, for example, one from each group is selected plus one more from the remaining functions.

Table 1.

| Group 1 | Group 2 | Group 3 |
|---------|---------|---------|
| $\lvert a\rvert^2$ | $\lvert a+b\rvert^2$ | $\lvert a+ib\rvert^2$ |
| $\lvert b\rvert^2$ | $\lvert a-b\rvert^2$ | $\lvert a-ib\rvert^2$ |

Information of the absolute value of the received signal 'b' is not necessarily needed in a receiver application, but information of the relation $b/a$ of the received RF signal 'b' and the local oscillator frequency 'a' is important. In this case, the functions of Group 1 in Table 1 are not necessarily needed in the receiver application, because these functions do not provide information of the phase difference between the received RF signal and the local oscillator frequency, but they can be used for absolute amplitude determination.

The functions of Group 2 and 3 of the Table 1 can be used to determine the ratio 'b/a' between the received RF signal and the local oscillator frequency. These four equations ([5]...[8]) can be divided into components as follows:

$$P1 = \lvert a+b\rvert^2 = (a_x + b_x)^2 + (a_y + b_y)^2 = a_x^2 + b_x^2 + a_y^2 + b_y^2 + 2\,a_x b_x + 2\,a_y b_y \qquad [5]$$

$$P2 = \lvert a-b\rvert^2 = (a_x - b_x)^2 + (a_y - b_y)^2 = a_x^2 + b_x^2 + a_y^2 + b_y^2 - 2\,a_x b_x - 2\,a_y b_y \qquad [6]$$

$$P3 = \lvert a+ib\rvert^2 = (a_x - b_y) + (a_y + b_x)^2 = a_x^2 + b_x^2 + a_y^2 + b_y^2 - 2\,a_x b_y + 2\,a_y b_x \qquad [7]$$

$$P4 = \lvert a-ib\rvert^2 = (a_x + b_y)^2 + (a_y - b_x)^2 = a_x^2 + b_x^2 + a_y^2 + b_y^2 + 2\,a_x b_y - 2\,a_y b_y \qquad [8]$$

Three of the above equations are needed to calculate the I and Q components. If all four equations are used, the following formulas can be derived:

$$\text{I-component} = P1 - P2 = 4\,a_x b_x + 4\,a_y b_y = 4\,I\lvert a\rvert^2 \qquad [9]$$

$$\text{Q-component} = P4 - P3 = 4\,a_x b_y - 4\,a_y b_x = 4\,Q\lvert a\rvert^2, \qquad [10]$$

where I and Q refer to the markings in formulas [2] and [3].

The difference between the power readings P1 and P2 represents the 0-phase part of the baseband signal, and the difference between the power readings P4 and P3 represents the 90° phase-shift part of the baseband signal. Table 2 shows the specifications of the I and Q components on the basis of different power readings P1, P2, P3 and P4.

Table 2

| Equations used | I-component | Q-component |
|----------------|-------------|-------------|
| P1, P2, P3, P4 | P1 - P2 | P4 - P3 |
| P1, P2, P3 | P1 - P2 | P1 + P2 - 2 P3 |

Table 2   (continued)

| Equations used | I-component | Q-component |
| --- | --- | --- |
| P1, P2, P4 | P1 - P2 | 2 P4 - P1 - P2 |
| P2, P3, P4 | P3 + P4 - 2 P2 | P4 - P3 |
| P1, P3, P4 | 2P1 - P3 - P4 | P4 - P3 |

The phase angle $\phi$ can be calculated by using the equations [4], [9] and [10], whereby we get the formulas:

$$4\, |a|\, |b| \cos \phi = \text{I-component} \qquad [11]$$

$$4\, |a|\, |b| \sin \phi = \text{Q-component} \qquad [12]$$

These can also be presented as tangent, whereby we get the formula:

$$\tan(\phi) = \frac{\text{Q-component}}{\text{I-component}} \qquad [13]$$

In the formulas, the I and Q components can be produced in the manner shown in Table 2 from the power readings P1, P2, P3 and P4.

In the coherent receiver (Figure 2), the first adder 16 produces the difference of the first power signal P1 and the second power signal P2, whereby the output signal (I-component) of the first adder 16 can be presented in the form (formula 11):

$$V_{21} = P_1 - P_2 = 4ab * \cos(\phi(t)) \qquad [14]$$

Correspondingly, the output signal $V_{43}$ of the second adder 17 presents the difference between the local oscillator frequency LO and the received RF signal, when the signals have a 90° phase difference. This can also be presented as follows (formula 12):

$$V_{43} = P_4 - P_3 = 4ab * \sin(\phi(t)) \qquad [15]$$

From the formulas [14] and [15] it can be seen, for example, that the output signals $V_{21}$, $V_{43}$ are proportional to the product of the amplitudes of the received radio frequency signal RF and the local oscillator frequency LO. Alternatively, the adjustment of the amplification can also be implemented by controlling the power (GC1) of the local oscillator frequency LO.

For keeping the local oscillator frequency LO in the same phase as the received signal RF, a feedback loop 23 has been formed in the coupling of Figure 1, whereby the signal produced by the second adder 17, low-pass filtered and amplified, is led to the local oscillator 7. The local oscillator 7 includes a known control circuit (not shown), which on the basis of the control signal controls the phase of the local oscillator frequency LO. Thus the local oscillator frequency LO and the received radio-frequency signal RF are in the same phase, and so

$$\phi(t) = 0 \qquad [16]$$

$$4ab * \cos(\phi(t)) = 4ab \qquad [17]$$

$$4ab * \sin(\phi(t)) = 0 \qquad [18]$$

As the signal $V_{43}$ is proportional to the difference between the frequency of the received RF signal and the local oscillator frequency LO, the phase information can be produced by deriving the signal $V_{43}$ (d/dt[$V_{43}$]). Thus the phase information is received from the output of the derivator 22.

When desired, the automatic amplification control can be implemented both in the coherent and the incoherent receiver preferably so that the output signal of the first amplifier 19 is further low-pass filtered and amplified and led to the amplification control device 24. The amplification control device controls the power of the local oscillator frequency LO in the second input port 6 of the six-port junction.

Another possibility is to control the amplification of the amplifiers 16 and 17 (GC2). In order to maintain a good balance between the channels, the change of amplification must be of equal amount in the amplifiers 16 and 17.

A direct conversion receiver 1 according to the invention can also be implemented by producing many demodulation signals with the methods presented in Table 2, whereby the actual demodulation signals $V_{21}$, $V_{43}$ are produced by combining the signals produced by different methods. Thus the effect of a possible error in one power signal P1, P2, P3, P4 can be essentially eliminated. When a digital signal processing unit is used, this alternative can be implemented programmably. On the other hand, when implemented with analog technique only, more adders and possibly also low-pass filters are needed.

The operation of a receiver in accordance with the invention and a conventional receiver implemented with mixers are compared in the following. In a mixer the diode is used as a switch, but the six-port junction uses the diode as a power detector. In a mixer, all the signals in the reception frequency band ($\omega_{RF}t + \omega_1 t + \omega_2 t$ ...) are multiplied by the local oscillator frequency ($\omega_{LO}t$). Here $\omega_{RF}$ represents the received, desired signal, and $\omega_1 t$ etc. represent the interfering signals (of the adjacent channels). This is presented mathematically by the following formula:

$$\sin(\omega_{LO}t) * (\sin(\omega_{RF}t) + \sin(\omega_1 t) + \sin(\omega_2 t) + ...)$$

$$\sim \cos(\omega_{LO}t - \omega_{RF}t) + \cos(\omega_{LO}t - \omega_1 t) + \cos(\omega_{LO}t - \omega_2 t) ... +$$

$$\text{higher order terms} \tag{27}$$

In a six-port junction all the signals of the received channel frequency are summed to the local oscillator frequency either in the same phase or with a 90° phase difference in different ports, whereby the signals produced by summing can be presented as

$$(\sin(\omega_{LO}t + \phi_1) + \sin(\omega_{RF}t + \phi_k) + \sin(\omega_1 t + \phi_k) + \sin(\omega_2 t + \phi_k)...). \tag{28}$$

Here, too, $\omega_{RF}$ represents the signal received and wanted, and $\omega_1 t$ etc. represent the interfering signals (of the adjacent channels). The phase difference ($\phi$) between the signals is thus 0 or $\pm$ 90° (nominal value).

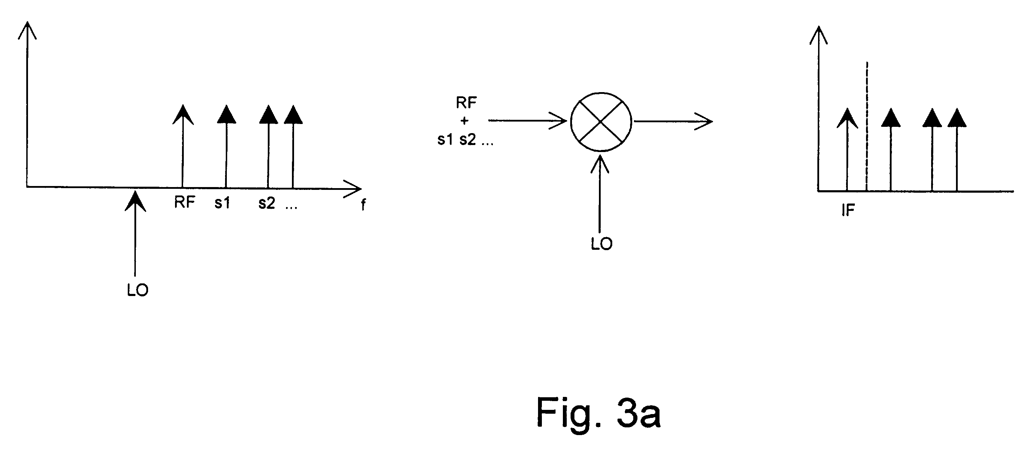

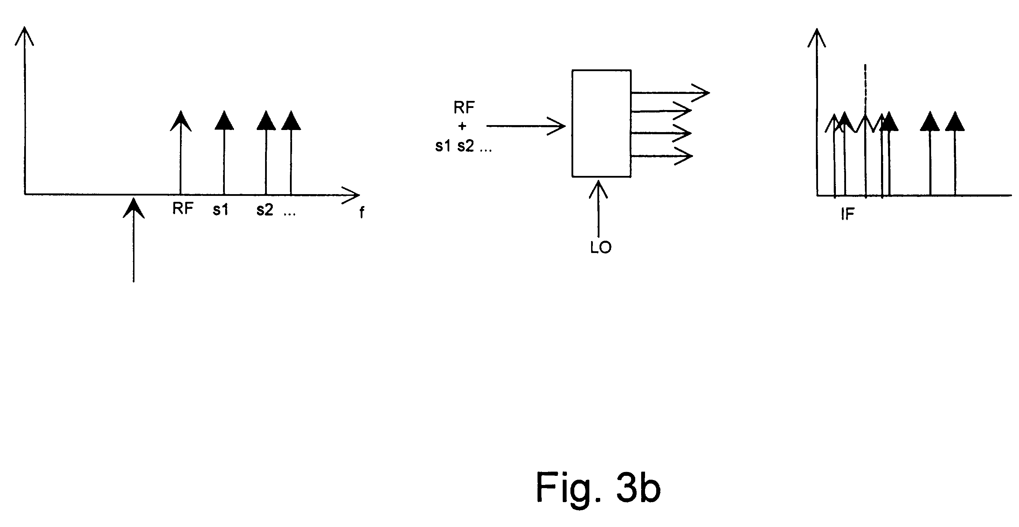

Figure 3a shows the frequency spectrum of the output of the mixer in the frequency domain, and similarly Figure 3b shows the frequency spectrum of one port of the six-port junction in the frequency domain. The power measurement devices 12, 13, 14, 15 square the signals produced by the six-port junction, whereby we get

$$(\sin(\omega_{LO}t + \phi_1) + \sin(\omega_{RF}t + \phi_k) + \sin(\omega_1 t + \phi_k) + \sin(\omega_2 t + \phi_k)...)^2$$

$$\sim \cos(\omega_{LO}t - \omega_{RF}t + \phi_1 - \phi_k) + \cos(\omega_{LO}t - \omega_1 t + \phi_1 - \phi_k) +$$

$$\cos(\omega_{LO}t - \omega_2 t + \phi_1 - \phi_k) + \underline{\cos(\omega_2 t - \omega_1 t + \phi_k - \phi_k)}...$$

$$+ \text{higher order terms} \tag{29}$$

It is to be noted that the underlined signal of formula [29] does not contain phase shift generated by the six-port. In any case, this signal can be situated in the baseband frequency band (Figure 3b).

In order to determine whether the baseband intermodulation results cancel each other out when the power signals of the output ports of the six-port junction are summed, an interfering signal 'c' is added to the equations of formulas [5]...[8]. Thus we get the additional terms:

$$P1 = |a + b + c|^2 = ... + c_x^2 + c_y^2 + 2\,a_x c_x + 2\,b_x c_x + 2\,a_y c_y + 2\,b_y c_y$$

$$P2 = |a - b - c|^2 = ...+ c_x^2 + c_y^2 - 2\,a_x c_x + 2\,b_x c_x - 2\,a_y c_y + 2\,b_y c_y$$

$$P3 = |a + ib + ic|^2 = ... + c_x^2 + c_y^2 - 2\,a_x c_y + 2\,b_y c_y + 2\,a_y c_x + 2\,b_x c_x$$

$$P4 = |a - ib - ic|^2 = ... + c_x^2 + c_y^2 + 2\,a_x c_y + 2\,b_y c_y - 2\,a_y c_x + 2\,b_x c_x$$

When the differences P1 - P2 and P4 - P3 are formed, the following additional terms are obtained to the equations [9] and [10]:

$$\text{I-component} = ... + 4\,a_x c_x + 4\,a_y c_y$$

$$\text{Q-component} = ... + 4\,a_x c_y - 4\,a_y c_x$$

These represent a signal with a frequency of ($\omega_{LO}$ - $\omega_1$), and this can be filtered out. From this it can be seen that when ideal ($x^2$) power measurement is used, the signals of the adjacent channels do not cause intermodulation results to the baseband frequency. Possible variation of the level of the local oscillator frequency LO does not cause an error between the I and Q components either, because the errors caused by the level variation are cancelled in the adders 16, 17.

By the method according to the invention it is possible to implement a direct conversion receiver, by which the information sent by phase modulation can be received and converted into phase and amplitude information.


**Claims**

1.  A method for receiving and demodulating modulated information by a direct conversion receiver, which comprises a six-port junction (4), **characterized** in that the demodulation is carried out analogically.

2.  A method according to Claim 1, in which the received, radio-frequency signal RF is led to the first input port (5) of the six-port junction (4), and the local oscillator frequency (LO) is led to the second input port (6), whereby there are produced in the six-port junction

    -   the first output signal (S1 ) by summing the received radio-frequency signal (RF) and the local oscillator frequency (LO),
    -   the second output signal (S2) by subtracting the local oscillator frequency (LO) from the received radio-frequency signal (RF),
    -   the first output signal (S3) by summing the received radio-frequency signal (RF) and the local oscillator frequency (LO) so that there is a 90° phase difference between the signals (RF, LO), and
    -   the fourth output signal (S4) by subtracting the local oscillator frequency (LO) from the radio-frequency signal (RF) so that there is a 90° phase difference between the signals (RF, LO),

    whereby the power signals (P1, P2, P3, P4) of the output signals (S1, S2, S3, S4) are produced in the method, **characterized** in that the demodulation of the I-component of the transmitted information is carried out by subtracting the second power signal (P2) from the first power signal (P1), and the demodulation of the Q-component of the transmitted information is carried out by subtracting the third power signal (P3) from the fourth power signal (P4).

3.  A method according to Claim 1, in which the received, radio-frequency signal (RF) is led to the first input port (5) of the six-port junction (4), and the local oscillator frequency (LO) is led to the second input port (6), whereby there are produced in the six-port junction

    -   the first output signal (S1 ) by summing the received radio-frequency signal (RF) and the local oscillator frequency (LO),
    -   the second output signal (S2) by subtracting the local oscillator frequency (LO) from the received radio-frequency signal (RF),

- the third output signal (S3) by summing the received radio-frequency signal (RF) and the local oscillator frequency (LO) so that there is essentially a 90° phase difference between the signals (RF, LO), and
- the fourth output signal (S4) by subtracting the local oscillator frequency (LO) from the received radio-frequency signal (RF) so that there is essentially a 90° phase difference between the signals (RF, LO),

whereby the power signals (P1, P2, P3, P4) of the output signals (S1, S2, S3, S4) are produced in the method, **characterized** in that the demodulation of the signal ($V_{21}$) corresponding to the amplitude of the transmitted information is carried out by subtracting the second power signal (P2) from the first power signal (P1), and the demodulation of the signal ($V_{43}$) corresponding to the phase of the transmitted information is carried out by subtracting the third power signal (P3) from the fourth power signal (P4).

4. A method according to any one of the preceding Claims 1 to 3, **characterized** in that the intensity of the demodulated signal is controlled at least partly by controlling the level of the local oscillator frequency (LO).

5. A method according to Claim 4, **characterized** in that the level control signal (GC1 ) of the local oscillator frequency is produced from the demodulated I-signal or the demodulated amplitude signal ($V_{21}$) preferably by low-pass filtering.

6. An incoherent direct conversion receiver (1) for receiving the information transmitted as modulated, which receiver comprises a six-port junction (4), to the first input port (5) of which the received radio-frequency signal (RF) is led, and to the second input port (6) of which the local oscillator frequency is led, whereby the six-port junction comprises

- means (4, 8) for producing the first output signal (S1) by summing the received radio-frequency signal (RF) and the local oscillator frequency (LO),
- means (4, 9) for producing the second output signal (S2) by subtracting the local oscillator frequency (LO) from the received radio-frequency signal (RF),
- means (4, 10) for producing the third output signal (S3) by summing the received radio-frequency signal (RF) and the local oscillator frequency so that there is a 90° phase difference between the signals (RF, LO) and
- means (4, 11) for producing the fourth output signal (S4) by subtracting the local oscillator frequency from the received radio-frequency signal (RF) so that there is a 90° phase difference between the signals (RF, LO), and
- means (12, 13, 14, 15) for producing the power signals (P1, P2, P3, P4) of the output signals (S1, S2, S3, S4),

**characterized** in that the receiver (1) also comprises

- means (16, 18, 19) for producing a signal ($V_{21}$) corresponding to the I-signal of the transmitted information, and
- means (17, 20, 21) for producing a signal ($V_{43}$) corresponding to the Q-signal of the transmitted information.

7. A coherent direct conversion receiver (1) for receiving information sent as modulated, which receiver comprises a six-port junction (4), to the first input port (5) of which the received radio-frequency signal (RF) is led and to the second input port (6) of which the local oscillator frequency (LO) is led, whereby the six-port junction comprises

- means (4, 8) for producing the first output signal (S1) by summing the received radio-frequency signal (RF) and the local oscillator frequency (LO),
- means (4, 9) for producing the second output signal (S2) by subtracting the local oscillator frequency (LO) from the received radio-frequency signal (RF),
- means (4, 10) for producing the third output signal (S3) by summing the received radio frequency signal (RF) and the local oscillator frequency (LO) so that there is a phase difference of 90° between the signals (RF, LO), and
- means (4, 11) for producing the fourth output signal (S4) by subtracting the local oscillator frequency (LO) from the received radio frequency signal (RF) so that there is a 90° phase difference between the signals (RF, LO), and
- means (12, 13, 14, 15) for producing the power signals (P1, P2, P3, P4) of the output signals (S1, S2, S3, S4),

**characterized** in that the receiver (1) also comprises

- means (16, 18, 19) for producing a signal ($V_{21}$) corresponding to the amplitude of the transmitted information, and

- means (17, 20, 21, 22) for producing a signal ($V_{43}$) corresponding to the phase of the transmitted information.

8. A receiver according to Claim 6, **characterized** in that

   - the means (16, 18, 19) for producing a signal corresponding to the I-component of the transmitted information comprise a first adder (16), and
   - the means (17, 20, 21) for producing a signal corresponding to the Q-component of the transmitted information comprise another adder (17).

9. A receiver (1) according to Claim 7, **characterized** in that

   - the means (16, 18, 19) for producing a signal ($V_{21}$) corresponding to the amplitude of the transmitted information comprise a first adder (16), and
   - the means (17, 20, 21, 22) for producing a signal ($V_{43}$) corresponding to the phase of the transmitted information comprise another adder (17).

10. A receiver (1) according to any one of the preceding Claims 6 to 9, **characterized** in that the receiver (1) also comprises means for controlling the intensity of the local oscillator frequency (LO).

Fig. 1

10

Fig. 2

Fig. 3a

Fig. 3b